# EUROPÄISCHE PATENTSCHRIFT

(11) **EP 3 893 006 B1**
(45) Veröffentlichungstag und Bekanntmachung des Hinweises auf die Patenterteilung: **31.12.2025**
(21) Anmeldenummer: 21166737.3
(22) Anmeldetag: 01.04.2021
(51) Int. Cl.: G01R 15/18, G01R 19/10, H02H 3/33

(54) **ELEKTRISCHE SCHALTUNGSANORDNUNG UND VERFAHREN ZUR GALVANISCH GETRENNTEN, ALLSTROMSENSITIVEN DIFFERENZSTROM-MESSUNG MIT HOHER AUFLÖSUNG**
ELECTRICAL CIRCUIT AND METHOD FOR GALVANICALLY SEPARATE, ALL-CURRENT SENSITIVE DIFFERENTIAL CURRENT MEASUREMENT WITH HIGH RESOLUTION
AGENCEMENT DE CIRCUITS ÉLECTRIQUES ET PROCÉDÉ DE MESURE DE COURANT DIFFÉRENTIEL GALVANIQUEMENT ISOLÉE, SENSIBLE À TOUS LES COURANTS, À HAUTE RÉSOLUTION

(30) Priorität: 09.04.2020 DE 102020110000
(43) Veröffentlichungstag der Anmeldung: 13.10.2021
(73) Patentinhaber: Bender GmbH & Co. KG, 35305 Grünberg (DE)
(72) Erfinder: BECKER, Pascal, 35305 Grünberg (DE)
(74) Vertreter: advotec.

(56) Entgegenhaltungen:
- EP-A1- 2 813 856
- EP-A2- 0 403 990
- JP-A- 2003 298 413
- JP-A- 2011 247 765
- JP-A- 2012 002 723
- JP-A- 2014 119 345
- WANG NONG ET AL: "Self-Oscillating Fluxgate-Based Quasi-Digital Sensor for DC High-Current Measurement", IEEE TRANSACTIONS ON INSTRUMENTATION AND MEASUREMENT, IEEE SERVICE CENTER, PISCATAWAY, NJ, US, vol. 64, no. 12, 1 December 2015 (2015-12-01), pages 3555 - 3563, XP011589133, ISSN: 0018-9456, [retrieved on 20151106], DOI: 10.1109/TIM.2015.2444258

## Beschreibung

Die Erfindung betrifft eine elektrische Schaltungsanordnung und ein Verfahren zur galvanisch getrennten, allstromsensitiven Differenzstrom-Messung mit hoher Auflösung.

Bekannt sind Messvorrichtungen und Messverfahren zur Überwachung elektrischer Anlagen, die auf dem Differenzstrom-Messprinzip beruhen.

Derartige Messvorrichtungen basieren auf der Tatsache, dass im fehlerfreien Betrieb einer elektrischen Anlage die vektorielle Summe der Ströme (Primärstrom) auf allen aktiven Leitern einer Zuleitung, beispielsweise der Leitung eines Stromversorgungssystems, gleich Null ist und somit kein Magnetfeld in einem die Zuleitung umschließenden, magnetisierbaren Ringkern eines Messstromwandlers existiert. Entsteht aber beispielsweise aufgrund eines Isolationsfehlers ein Fehlerstrom, der außerhalb der Zuleitung abfließt, ergibt sich primärseitig ein Differenzstrom. Der durch diesen Differenzstrom innerhalb des Ringkerns hervorgerufene, veränderliche Magnetfluss induziert in einer Sekundärspule des Messstromwandlers eine Spannung, deren Größe eine Aussage über die Höhe des Differenzstroms erlaubt.

Ist der Differenzstrom sehr klein oder müssen bei einem großen Differenzstrom kleine Änderungen erfasst werden, so benötigt man eine Messvorrichtung mit hoher Sensitivität. Für bestimmte Anwendungsgebiete, beispielsweise zur Erfassung eines Prüfstromimpulses in ungeerdeten Stromversorgungssystemen, kann es daher erforderlich sein, auch sehr geringe Differenzströme in dem Bereich kleiner als 1mA oder sogar kleiner als 10µA erfassen zu können.

Diese Beschränkung in der Messauflösung führt dazu, dass beispielsweise bei der Bestimmung eines fehlerhaften Leitungsabgangs in einem ungeerdeten Stromversorgungssystem ein zweiter, in der Regel strombegrenzter (Fehlerstrom-)Pfad gegen Erde geschaltet werden muss, um einen signifikanten messbaren Differenzstrom durch den Messstromwandler fließen zu lassen. Dieses Vorgehen allerdings kann in ausgewählten Szenarien aus technischen oder regulatorischen Gründen unzulässig sein.

Bekannte Verfahren zur allstromsensitiven Differenzstrommessung mittels eines Messstromwandlers, wie beispielsweise in der Offenlegungsschrift EP 2 813 856 A1 und der Patentschrift EP 2 813 856 B1 offenbart, nutzen Oszillatorschaltungen, mit der die Magnetisierungskurve des Wandlerkerns des Messstromwandlers durch einen gesteuerten sekundärseitigen Stromfluss zwischen einer oberen und einer unteren Sättigung oszillierend durchfahren wird. Aus dem zeitlichen Verlauf dieser Oszillation lassen sich zwei Zustände definieren und durch die Bestimmung der Verweilzeiten in dem jeweiligen Zustand lässt sich eine Messgröße bilden, aus der sich der primärseitige Differenzstrom durch den Messstromwandler ermitteln lässt. Allerdings kommt in der genannten Patentschrift eine anwendungsspezifische integrierte Schaltung (ASIC) zum Einsatz, welche einen hohen Entwicklungsaufwand und hohe Initialkosten erforderlich macht.

Auch weitere bekannte Schaltungsanordnungen zur Differenzstrommessung beruhen im weiteren Sinne auf integrierten Schaltungen, bilden also baulich und funktional eine Einheit, die aufgrund ihrer Komplexität einen hohen Entwicklungsaufwand erfordert.

Weiter ist aus der IEEE-Veröffentlichung "Self-Oscillating Fluxgate-Based Quasi-Digital Sensor for DC High-Current Measurement" von WANG NONG et al. [erschienen in IEEE TRANSACTIONS ON INSTRUMENTATION AND MEASUREMENT, IEEE SERVICE CENTER, PISCATAWAY, NJ, US, Bd. 64, Nr. 12, 1. Dezember 2015 (2015-12-01), Seiten 3555-3563, XP011589133, ISSN: 0018-9456, DOI: 10.1109/TIM.2015.2444258] ein quasi-digitaler DC Stromsensor zur Hochstrommessung basierend auf einem selbstoszillierenden Fluxgate Verfahren bekannt. Der Sensor weist eine Oszillatorschaltung mit einem Operationsverstärker und einem nachfolgenden Leistungsverstärker als Treiberschaltung zur Erzeugung eines invertierenden Erregerstroms für die Speisung eines nichtlinearen Messtransformators auf. Die alternierende Erregerspannung wird in ein positives pulsförmiges Signal umgewandelt, welches anschließend einem mikroprozessorbasierten Detektor zugeleitet wird, um ein Tastverhältnis und damit den zu messenden Primärstrom zu ermitteln.

Die Offenlegungsschriften JP 2012 002723 A, JP 2014 119345 A und JP 2011 247765 A beschreiben einen Stromdetektor zur Fehlerstromerkennung in verschiedenen Ausgestaltungen. Die Detektoren beruhen ebenfalls auf dem Fluxgate-Prinzip und weisen eine Oszillatorschaltung als Erregerkreis auf, die einen invertierenden Erregerstrom in eine Erregerspule eines Magnetkerns einspeist. Eine der Oszillatorschaltung nachgeschaltete Erkennungsschaltung bestimmt aus dem Tastverhältnis der bipolaren Erregerspannung den zu messenden Strom. Auch diese Implementierungen weisen eine hohe schaltungstechnische Komplexität und damit einen hohen Kostenaufwand auf.

Die Offenlegungsschrift EP 0 403 990 A2 zeigt einen hochauflösenden Taktgenerator mit einem N-stufigen Ringoszillator und die Offenlegung JP 2003 298413 A beschreibt einen Taktgenerator, wobei der Takt durch Frequenzteilung einer PLL mit VCO, die als Ringoszillator aufgeführt ist, erzeugt wird. Beide letztgenannten Druckschriften zeigen somit Taktgeneratoren ohne deren Verwendung zur Differenzstrommessung.

Der vorliegenden Erfindung liegt somit die Aufgabe zugrunde, eine elektrische Schaltungsanordnung und ein Messverfahren zur galvanisch getrennten, allstromsensitiven Differenzstrommessung zu schaffen, welche eine hochauflösende Messung des Differenzstroms erlauben und zugleich schaltungstechnisch und wirtschaftlich effizient implementierbar sind.

Diese Aufgabe wird durch eine elektrische Schaltungsanordnung zur galvanisch getrennten, allstromsensitiven Differenzstrommessung gelöst, die folgende Elemente umfasst: einen Ringkern-Stromwandler mit mindestens einer Sekundärwicklung zur Erfassung eines Differenzstroms, eine Treiberschaltung zur Bestromung der Sekundärwicklung, eine erste Oszillatorschaltung zur Steuerung der Treiberschaltung und zur Erzeugung eines zeitmodulierten, binären Oszillatorsignals mit Verweilzeiten in einem Zustand 1 und einem Zustand 2, eine zweite Oszillatorschaltung zur hochauflösenden Bestimmung der jeweiligen Verweilzeit in den Zuständen 1 und 2 mittels eines Taktsignals mit einer von dem Oszillatorsignal unabhängigen Taktrate, eine Auswerteeinrichtung zur Auswertung der Verweilzeiten und eine Datenschnittstelle zur Ausgabe eines Differenzstrom-Messwertes, wobei die Treiberschaltung und die zweite Oszillatorschaltung jeweils als baulich getrennte, integrierte Schaltkreise ausgeführt sind und die zweite Oszillatorschaltung aus einer geschlossenen Reihenschaltung von invertierenden Elementen mit mindestens einer Rückkopplung besteht.

Die Erfindung geht von einem Ringkern-Stromwandler zur Erfassung des Differenzstroms aus, dessen Magnetisierungskurve einen ausgeprägten positiven und negativen Sättigungsbereich aufweist, zwischen denen ein näherungsweise linearer Bereich verläuft. Der Ringkern-Stromwandler weist mindestens eine Sekundärwicklung auf, die von einer Treiberschaltung bestromt wird.

Die Treiberschaltung wird von der ersten Oszillatorschaltung in der Weise angesteuert, dass die Magnetisierungskurve in Folge des Stromflusses durch die Sekundärwicklung in beiden Richtungen zwischen der positiven und der negativen Sättigung oszillierend durchfahren wird.

Dies wird durch eine Treiberschaltung ermöglicht, welche die Polarität der an der Sekundärwicklung angelegten Spannung invertiert. Die Unterscheidung zwischen dem linearen Bereich und dem jeweiligen Sättigungsbereich auf der Magnetisierungskurve erfolgt in der ersten Oszillatorschaltung durch eine betragliche Messung des Sekundärstroms und den Vergleich mit einem hinreichend hoch gewählten Sättigungs-Grenzwert, welcher einem Stromwert im Sättigungsbereich des Kernmaterials entspricht. Der Sekundärstrom wird hierzu zurückgekoppelt.

Überschreitet der Sekundärstrom den Sättigungs-Grenzwert, kippt die erste Oszillatorschaltung (Kippschaltung). Die Polarität an der Sekundärwicklung wird dann invertiert und der magnetische Fluss in dem Ringkern aus dem momentanen Sättigungsbereich heraus zurück bis in die jeweils entgegengesetzte Sättigung getrieben.

Unter Auswertung der Nulldurchgänge des Sekundärstroms- also in dem allein durch den Differenzstrom bestimmten Arbeitsunkt auf der Magnetisierungskurve - und aus dessen Kipppunkten - also in den Sättigungsbereichen auf der Magnetisierungskurve - kann aus dem Sekundärstrom-Verlauf ein binäres Oszillatorsignal mit Verweilzeiten in einem Zustand 1 (High-Phase) und in einem Zustand 2 (Low-Phase) abgeleitet werden.

Die Verweilzeiten im Zustand 1 und im Zustand 2 sind dabei ausgehend von dem durch den Differenzstrom vorgegebenen Arbeitspunkt auf der Magnetisierungskennlinie bis zum Erreichen des jeweiligen Sättigungspunktes in Abhängigkeit der Lage des Arbeitspunktes unterschiedlich lange und führen damit zu einem zeitlich modulierten Oszillatorsignal.

Das Durchfahren der Magnetisierungskurve wird also über eine möglichst lineare Funktion (linearer Bereich der Magnetisierungskurve) in die Verweilzeiten des binären Oszillatorsignals abgebildet, wobei sich die den durchfahrenen Strecken auf der Magnetisierungskurve entsprechenden Verweilzeiten in Abhängigkeit des Arbeitspunktes ergeben.

Das zeitmodulierte binäre Oszillatorsignal weist daher je nach Lage des Arbeitspunktes und damit in Abhängigkeit des Differenzstroms unterschiedlich lange High-/Lowphasen (Zustand 1/Zustand 2) auf.

Die Bestimmung der jeweiligen Verweilzeit in den Zuständen 1 und 2 erfolgt mittels einer zweiten Oszillatorschaltung, die ein hochfrequentes Taktsignal erzeugt. Dieses Taktsignal ist unabhängig von dem Oszillatorsignal, weist aber eine Taktrate auf, die um ein Vielfaches höher als eine Grundfrequenz des Oszillatorsignals ist und in einem Bereich größer 1GHz liegt. Dadurch ist in vorteilhafter Weise eine hohe zeitliche Auflösung im Bereich kleiner als 1ns möglich, sodass geringe Unterschiede in den Verweilzeiten und damit sehr kleine Differenzströme und sehr kleine Differenzstromänderungen feststellbar sind.

Die Anzahl der in der zweiten Oszillatorschaltung innerhalb der jeweiligen Verweilzeiten mit der Taktrate gezählten Taktimpulse wird in der Auswerteeinrichtung bestimmt und führt nach einer geeigneten Signalverarbeitung (Filterung) zu einem dem Differenzstrom proportionalen Differenzstrom-Messwert.

Über die Datenschnittstelle wird der Differenzstrommesswert in digitaler und/oder analoger Form ausgegeben.

Erfindungsgemäß ist die elektrische Schaltungsanordnung modular in der Form aufgebaut, dass die Treiberschaltung und die zweite Oszillatorschaltung jeweils als baulich getrennte, integrierte Schaltkreise ausgeführt sind.

Sowohl die Treiberschaltung als auch die zweite Oszillatorschaltung sind somit als separat verfügbare, integrierte Schaltkreise (Standardbauteile) ausgebildet, wobei insbesondere die zweite Oszillatorschaltung infolge der hohen Taktrate eine hochauflösende Bestimmung der jeweiligen Verweilzeiten ermöglicht.

Durch die Verwendung von ausgewählten Standardbauteilen lässt sich der technische Vorteil einer hochfrequenten Taktrate und der daraus resultierenden hohen Messauflösung mit wirtschaftlicher Effizienz verbinden.

Erfindungsgemäß besteht die zweite Oszillatorschaltung aus einer geschlossenen Reihenschaltung von invertierenden Elementen mit mindestens einer Rückkopplung.

Mit dieser Schaltungsstruktur ist im Vergleich zu einer reinen digitalelektronischen Erzeugung eines Taktsignals, beispielsweise in einem Mikrocontroller, eine höhere Taktrate erzielbar und damit eine erhebliche Verbesserung der Messauflösung um mehrere Größenordnungen gegeben ohne dabei den Messbereich im Vergleich zu aus dem Stand der Technik bekannten Verfahren nach oben zu beschränken.

Es lässt sich ein großer Dynamikbereich erzielen, der es ermöglicht, auch kleine Differenzstromänderungen in dem Nutzsignal, wie beispielsweise einen Prüfstromimpuls in einem 10.000-fach größeren Störsignal zu erfassen.

Bevorzugt ist die Auswerteeinrichtung als digitale Schaltung zur Erzeugung des Differenzstrom-Messwertes aus den Verweilzeiten konfiguriert. Die Auswerteeinrichtung umfasst dabei vorzugsweise als digitale Schaltung einen Mikroprozessor, auf dem Verfahren der digitalen Signalverarbeitung, wie beispielsweise eine Filterung oder Mittelwertbildung der Verweilzeiten implementiert sind, um den Differenzstrom-Messwert zu berechnen. Dabei können verschiedene programmierbare Filtercharakteristiken und auch eine absolute Differenzstrommessung mit Kalibrierung bzw. Nullpunktabgleich bereitgestellt werden.

Mit Vorteil ist die Datenschnittstelle zur Ausgabe des Differenzstrom-Messwertes als analoges und/oder digitales Signal konfiguriert.

Der Differenzstrom-Messwert wird als digitales Signal ausgegeben und/oder steht nach D/A-Umsetzung als analoges Signal zur Verfügung.

Die der Erfindung zugrunde liegende Aufgabe wird weiterhin gelöst durch ein Messverfahren zur galvanisch getrennten, allstromsensitiven Differenzstrommessung.

Das beanspruchte Messverfahren beschreibt die der erfindungsgemäßen elektrischen Schaltungsanordnung zugrunde liegenden Verfahrensschritte, um den Differenzstrom hochauflösend zu bestimmen. Insoweit treffen auch die vorgenannten für die elektrische Schaltungsanordnung zutreffenden technischen Wirkungen und daraus resultierenden Vorteile auf die Verfahrensmerkmale zu.

Insbesondere führen dabei die jeweils als baulich getrennte, integrierte Schaltkreise ausgeführte Treiberschaltung und die zweite Oszillatorschaltung zu der aufgabengemäß geforderten hohen Sensitivität und wirtschaftlichen Effizienz.

Weitere vorteilhafte Ausgestaltungsmerkmale ergeben sich aus der nachfolgenden Beschreibung und den Zeichnungen, die eine bevorzugte Ausführungsform der Erfindung beispielhaft erläutern.

Es zeigen:
- **Fig. 1**: eine Magnetisierungskurve eines Ringkern-Stromwandlers in schematischer Darstellung,
- **Fig. 2**: ein funktionales Blockschaltbild der erfindungsgemäßen elektrischen Schaltungsanordnung und
- **Fig. 3**: eine digitale Signalverarbeitung des Oszillatorsignals.

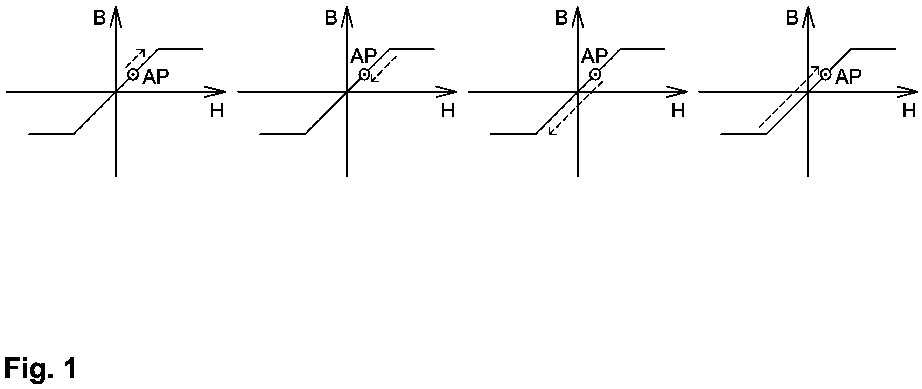

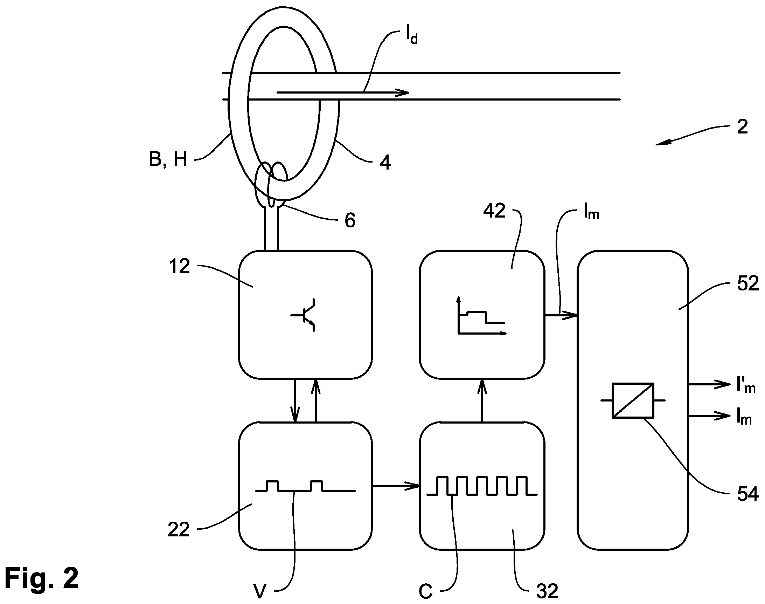

In **Fig.** 1 ist das Durchfahren der Magnetisierungskurve des Ringkernstromwandlers 4 **(****Fig. 2****)** schematisch dargestellt.

Die Magnetisierungskurve stellt die magnetischen Induktion B in Abhängigkeit der magnetischen Feldstärke H dar und besteht vorliegend aus einem linearen Abschnitt, der zwischen einem oberen und einem unteren Sättigungsbereich verläuft.

Ausgehend von dem durch den Differenzstrom I_{d} **(****Fig. 2****)** vorgegebenen Arbeitspunkt AP wird die Magnetisierungskurve zunächst durch einen zunehmenden Strom in der Sekundärwicklung (Sekundärstrom) in Richtung des positiven Sättigungszustands durchlaufen. In dem Arbeitspunkt AP beträgt der Wert des in der Sekundärwicklung fließenden Stroms null, sodass der Arbeitspunkt AP nur durch den primärseitig fließenden Differenzstrom I_{d} bestimmt wird. Das Erreichen des Sättigungsbereiches wird durch eine Betragsmessung des Sekundärstroms und den Vergleich mit einem hinreichend hoch gewählten Sättigungs-Grenzwert, welcher im Sättigungsbereich des Kernmaterials liegt, erkannt. Überschreitet der Sekundärstrom diesen Sättigungs-Grenzwert, kippt die erste Oszillatorschaltung. Die Polarität der Sekundärwicklung wird dann invertiert und der magnetische Fluss B im Kern aus dem Sättigungsbereich heraus zurück bis in die jeweils entgegengesetzte Sättigung getrieben.

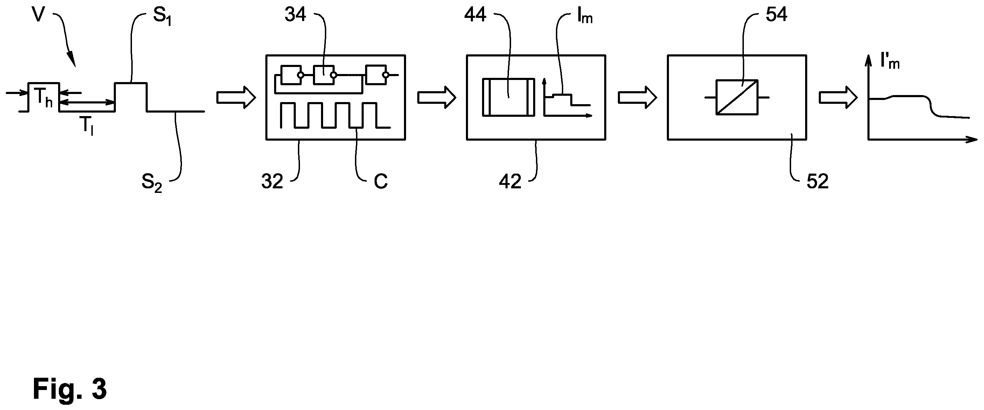

Aus dem Durchlaufen der Magnetisierungskurve wird ersichtlich, dass die Dauer eines zunehmenden/abnehmenden Sekundärstroms, also die Verweilzeiten Tₕ, Tₗ, **(****Fig. 3****)** abhängig ist von der Lage des Arbeitspunktes AP auf der Magnetisierungskurve. Aus der Kenntnis des Nulldurchgangs und der Kipppunkte des Sekundärstroms kann somit ein zeitmoduliertes, binäres Oszillatorsignal V **(****Fig. 3****)** mit Verweilzeiten Tₕ, Tₗ in einem Zustand 1 S₁ und einem Zustand 2 S₂ **(****Fig. 3****)** abgeleitet werden.

**Fig. 2** zeigt ein funktionales Blockschaltbild der erfindungsgemäßen elektrischen Schaltungsanordnung 2.

Der zu messende Differenzstrom I_{d} (Primärstrom) wird von einem Ringkern-Stromwandler 4 erfasst, wodurch sich ein bestimmter Arbeitspunkt AP auf der Magnetisierungskurve (Fig. 1) einstellt.

Zum Durchfahren der Magnetisierungskurve in beiden Richtungen weist der Ringkern-Stromwandler 4 eine Sekundärwicklung 6 auf, die von einer Treiberschaltung 12 bestromt wird. Die mit dem Stromfluss in der Sekundärwicklung 6 verknüpfte magnetische Feldstärke H erzeugt in dem Kernmaterial die magnetische Induktion B.

Die Treiberschaltung 12 wird von einer ersten Oszillatorschaltung 22 gesteuert, wobei unter Auswertung der Nulldurchgänge und der Kipppunkte des Sekundärstroms in der Sekundärwicklung 6 ein Oszillatorsignal V gewonnen wird.

Das Durchfahren der Magnetisierungskurve wird somit in die Verweilzeiten Tₕ, Tₗ **(****Fig. 3****)** mit einem Zustand 1 S₁ (High-Phase) und mit einem Zustand 2 S₂ (Low-Phase) abgebildet, wobei sich die den durchfahrenen Strecken auf der Magnetisierungskurve entsprechenden Verweilzeiten Tₕ, Tₗ in Abhängigkeit des durch den Differenzstrom I_{d} vorgegebenen Arbeitspunktes AP ergeben.

Befindet sich beispielsweise der Arbeitspunkt AP in Folge eines relativ hohen Differenzstroms I_{d} nahe dem oberen Sättigungspunkt auf dem linearen Streckenabschnitt der Magnetisierungskurve, so wird bei dem Durchfahren der Magnetisierungskurve ausgehend von dem Arbeitspunkt eine kürzere Strecke auf dem linearen Abschnitt durchlaufen als bei einem kleineren Differenzstrom - es ergibt sich eine kürzere Verweilzeit. Wie oben dargelegt, weist das auf diese Weise zeitmodulierte Oszillatorsignal V daher je nach Lage des Arbeitspunktes AP und damit in Abhängigkeit des Differenzstroms I_{d} unterschiedlich lange Verweilzeiten Tₕ, Tₗ in den Zuständen 1 S₁ und 2 S₂ auf.

Die Bestimmung der jeweiligen Verweilzeiten Tₕ, Tₗ erfolgt hochauflösend in einer zweiten Oszillatorschaltung 32 mittels eines hochfrequenten Taktsignals C, dessen Taktrate um ein Vielfaches höher ist als eine Grundfrequenz des zwischen den Zuständen 1 S₁ und 2 S₂ oszillierenden Oszillatorsignals V. Aus Untersuchungen ergibt sich, dass eine Taktrate größer als 1GHz und damit eine hohe zeitliche Auflösung von kleiner als 1ns möglich ist.

Die Auswertung (Zählung) der innerhalb der jeweiligen Verweilzeiten Tₕ, Tₗ ermittelten Taktimpulse erfolgt in einer Auswerteeinrichtung 42, welche ausgangsseitig einen dem Differenzstrom I_{d} proportionalen Differenzstrom-Messwert Iₘ bereitstellt. Dieser in digitaler Form vorliegende Differenzstrom-Messwert Iₘ kann über die Datenschnittstelle 52 direkt in digitalem Format Iₘ und/oder mittels eines D/A-Umsetzers 54 als analoger Differenzstrom-Messwert I'ₘ ausgegeben werden.

Fig. 3 zeigt in einem funktionalen Blockschaltbild die digitale Signalverarbeitung des Oszillatorsignals V.

Die Verweilzeiten Tₕ, Tₗ des Oszillatorsignals V in den Zuständen 1 S₁ und 2 S₂ werden in der zweiten Oszillatorschaltung 32 mittels eines hochfrequenten Taktsignals C hochauflösend (zeitlich) quantisiert. Dazu weist die zweite Oszillatorschaltung 32 eine geschlossene Reihenschaltung von invertierenden Elementen mit mindestens einer Rückkopplung 34 auf.

Die so bestimmten Verweilzeiten Tₕ, Tₗ werden in einer darauffolgenden Auswerteeinrichtung 42 mittels einer digitalen Schaltung 44, beispielsweise einem Mikrocontroller, ausgewertet.

An dem Ausgang der Auswerteeinrichtung 42 steht ein Differenzstrom-Messwert Iₘ bereit. Die Datenschnittstelle 52 leitet den digitalen Differenzstrom-Messwert Iₘ direkt und/oder über einen D/A-Umsetzer 54 als analogen Differenzstrom-Messwert I'ₘ weiter.

## Patentansprüche

1. Elektrische Schaltungsanordnung (2) zur galvanisch getrennten, allstromsensitiven Differenzstrommessung, umfassend einen Ringkern-Stromwandler (4) mit mindestens einer Sekundärwicklung (6) zur Erfassung eines Differenzstroms (I_{d}),
eine Treiberschaltung (12) zur Bestromung der Sekundärwicklung (6),
eine erste Oszillatorschaltung (22) zur Steuerung der Treiberschaltung (12) und zur Erzeugung eines zeitmodulierten, binären Oszillatorsignals (V) mit Verweilzeiten (Tₕ, Tₗ) in einem Zustand 1 (S₁) und in einem Zustand 2(S₂),
eine zweite Oszillatorschaltung (32) zur hochauflösenden Bestimmung der jeweiligen Verweilzeit (Tₕ, Tₗ) in den Zuständen 1 und 2 mittels eines Taktsignals (C) mit einer von dem Oszillatorsignal (V) unabhängigen Taktrate ,
eine Auswerteeinrichtung (42) zur Auswertung der Verweilzeiten (Tₕ, Tₗ) und
eine Datenschnittstelle (52) zur Ausgabe eines Differenzstrom-Messwertes (Iₘ, I'ₘ),
wobei die Treiberschaltung (12) und die zweite Oszillatorschaltung (32) jeweils als baulich getrennte, integrierte Schaltkreise ausgeführt sind und die zweite Oszillatorschaltung (32) aus einer geschlossenen Reihenschaltung von invertierenden Elementen mit mindestens einer Rückkopplung (34) besteht.

2. Elektrische Schaltungsanordnung (2) nach Anspruch 1,
**dadurch gekennzeichnet,**
**dass** die Auswerteeinrichtung (42) als digitale Schaltung (44) zur Erzeugung des Differenzstrom-Messwertes (Iₘ) aus den Verweilzeiten (Tₕ, Tₗ) konfiguriert ist.

3. Elektrische Schaltungsanordnung (2) nach Anspruch 1 oder 2,
**dadurch gekennzeichnet,**
**dass** die Datenschnittstelle (52) zur Ausgabe des Differenzstrom-Messwertes (Iₘ, I'ₘ) als analoges und/oder digitales Signal konfiguriert ist.

4. Messverfahren zur galvanisch getrennten, allstromsensitiven Differenzstrommessung, umfassend die Verfahrensschritte:
Erfassen eines Differenzstroms (I_{d}) mittels eines Ringkern-Stromwandlers (4) mit mindestens einer Sekundärwicklung (6),
Bestromen der Sekundärwicklung (6) mittels einer Treiberschaltung (12), welche als baulich getrennter, integrierter Schaltkreis ausgeführt ist,
Steuern der Treiberschaltung (12) und Erzeugen eines zeitmodulierten, binären Oszillatorsignals (V) mit Verweilzeiten (Tₕ, Tₗ) in einem Zustand 1 (S₁) und in einem Zustand 2 (S₂) mittels einer ersten Oszillatorschaltung (22),
Bestimmen der jeweiligen Verweilzeit (Tₕ, Tₗ) in den Zuständen 1 und 2 mittels einer zweiten Oszillatorschaltung (32), welche als baulich getrennter, integrierter Schaltkreis ausgeführt ist, durch Erzeugen eines Taktsignals (C) mit einer von dem Oszillatorsignal (V) unabhängigen Taktrate, die eine hohe zeitliche Auflösung bewirkt,
Auswerten der Verweilzeiten (Tₕ, Tₗ) mittels einer Auswerteeinrichtung (42),
Ausgeben eines Differenzstrom-Messwertes (Iₘ, I'ₘ) mittels einer Datenschnittstelle und
Erzeugen des Taktsignals (C) mittels einer geschlossenen Reihenschaltung von invertierenden Elementen mit mindestens einer Rücckopplung (34).

5. Messverfahren nach Anspruch 4,
**dadurch gekennzeichnet,**
**dass** in der Auswerteeinrichtung (42) mittels digitaler Filteralgorithmen aus den Verweilzeiten (Tₕ, Tₗ) der Differenzstrom-Messwert (Iₘ) gewonnen wird.

6. Messverfahren nach Anspruch 4 oder 5,
**dadurch gekennzeichnet,**
**dass** mittels der Datenschnittstelle (52) der Differenzstrom-Messwert (Iₘ, I'ₘ) als analoges und/oder digitales Signal ausgegeben wird.

## Claims

1. An electric circuit arrangement (2) for a galvanically insulated, AC/DC sensitive differential-current measurement, the electric circuit arrangement (2) comprising
a toroid current transformer (4) having at least one secondary winding (6) for detecting a differential current (I_{d}),
a driver circuit (12) for powering the secondary winding (6),
a first oscillator circuit (22) for controlling the driver circuit (12) and for generating a time-modulated binary oscillator signal (V) having dwell times (Tₕ, T₁) in a state 1 (S₁) and a state 2 (S₂),
a second oscillator circuit (32) for determining the corresponding dwell time (Tₕ, T₁) in the states 1 and 2 in high resolution by means of a clock signal (C) having a clock rate independent of the oscillator signal (V),
an evaluation device (42) for evaluating the dwell times (Tₕ, T₁), and
a data interface (52) for outputting a differential-current measuring value (Iₘ, I'ₘ),
the driver circuit (12) and the second oscillator circuit (32) each being realized as structurally individual, integrated circuits and the second oscillator circuit (32) consists of a closed series connection of inverting elements having at least one back coupling (34).

2. The electric circuit arrangement (2) according to claim 1, **characterized in that**
the evaluation device (42) is configured as a digital circuit (44) for generating a differential-current measuring value (Iₘ) from the dwell times (Tₕ, T₁).

3. The electric circuit arrangement (2) according to claim 1 or 2, **characterized in that**
the data interface (52) is configured as an analog and/or digital signal for outputting the differential-current measuring value (Iₘ, I'ₘ).

4. A measuring method for a galvanically insulated, AC/DC sensitive differential-current measurement, the measuring method comprising the following steps:
detecting a differential current (I_{d}) by means of a toroid current transformer (4) having at least one secondary winding (6),
powering the secondary winding (6) by means of a driver circuit (12) which is configured as a structurally individual, integrated circuit,
controlling the driver circuit (12) and generating a time-modulated binary oscillator signal (V) having dwell times (Tₕ, Tₗ) in a state 1 (S₁) and in a state 2 (S₂) by means of a first oscillator circuit (22),
determining the corresponding dwell time (Tₕ, Tₗ) in the states 1 and 2 by means of a second oscillator circuit (32), which is realized as a structurally individual, integrated circuit, by generating a clock signal (C) having a clock rate which is independent of the oscillator signal (V) and causes a high temporal resolution,
evaluating the dwell times (Tₕ, Tₗ) by means of an evaluation device (42),
outputting a differential-current measuring value (Iₘ, I'ₘ) by means of a data interface,
generating the clock signal (C) by means of a closed series connection of inverting elements having at least one back coupling (34).

5. The measuring method according to claim 4,
**characterized in that**
the differential-current measuring value (Iₘ) is won in the evaluation device (42) from the dwell times (Tₕ, Tₗ) by means of digital filtering algorithms.

6. The measuring method according to claim 4 or 5,
**characterized in that**
the differential-current measuring value (Iₘ, I'ₘ) is output as an analog and/or digital signal by means of the data interface (52).

## Revendications

1. Agencement de circuit (2) électrique pour une mesure galvaniquement isolée, sensible au courant alternatif/continu, d'un courant différentiel résiduel, l'agencement de circuit (2) électrique comprenant un transformateur de courant toroïdal (4) ayant au moins un enroulement secondaire (6) pour détecter un courant différentiel résiduel (I_{d}),
un circuit d'attaque (12) pour alimenter l'enroulement secondaire (6) en courant,
un premier circuit d'oscillateur (22) pour commander le circuit d'attaque (12) et pour générer un signal d'oscillateur (V) binaire, à modulation de temps et ayant des durées de temporisation (Tₕ, Tₗ) dans un état 1 (S₁) et dans un état 2 (S₂),
un deuxième circuit d'oscillateur (32) pour déterminer la durée de temporisation (Tₕ, Tₗ) correspondante dans les états 1 et 2 en haute résolution au moyen d'un signal d'horloge (C) ayant un taux d'horloge indépendant du signal d'oscillateur (V),
un dispositif d'évaluation (42) pour évaluer les durées de temporisation (Tₕ, Tₗ), et
une interface données (52) pour sortir une valeur mesurée du courant différentiel résiduel (Iₘ, I'ₘ),
le circuit d'attaque (12) et le deuxième circuit d'oscillateur (32) étant chacun réalisés sous forme de circuits intégrés et structurellement individuels, et le deuxième circuit d'oscillateur (32) consistant en un montage en série fermé d'éléments inverseurs ayant au moins une rétroaction (34).

2. Agencement de circuit (2) électrique selon la revendication 1, **caractérisé en ce que**
le dispositif d'évaluation (42) est configuré comme circuit numérique (44) pour générer une valeur mesurée du courant différentiel résiduel (Iₘ) à partir des durées de temporisation (Tₕ, Tₗ).

3. Agencement de circuit (2) électrique selon la revendication 1 ou la revendication 2,
**caractérisé en ce que**
l'interface données (52) est configurée comme signal analogique et/ou numérique pour sortir la valeur mesurée du courant différentiel résiduel (Iₘ, I'ₘ).

4. Procédé pour une mesure galvaniquement isolée, sensible au courant alternatif/continu, d'un courant différentiel résiduel, le procédé de mesure comprenant les étapes suivantes :
la détection d'un courant différentiel résiduel (I_{d}) au moyen d'un transformateur de courant toroïdal (4) ayant au moins un enroulement secondaire (6),
alimenter l'enroulement secondaire (6) en courant au moyen d'un circuit d'attaque (12) qui est configuré comme circuit intégré et
structurellement individuel,
la commande du circuit d'attaque (12) et la génération d'un signal d'oscillateur (V) binaire, à modulation de temps et ayant des durées de temporisation (Tₕ, Tₗ) dans un état 1 (S₁) et dans un état 2 (S₂) au moyen d'un premier circuit d'oscillateur (22),
la détermination de la durée de temporisation (Tₕ, Tₗ) correspondante dans les états 1 et 2 au moyen d'un deuxième circuit d'oscillateur (32),
qui est réalisé sous la forme d'un circuit intégré et structurellement individuel, en générant un signal d'horloge (C) ayant un taux d'horloge qui est indépendant du signal d'oscillateur (V) et qui provoque une haute résolution temporelle,
l'évaluation des durées de temporisation (Tₕ, Tₗ) au moyen d'un dispositif d'évaluation (42),
la sortie d'une valeur mesurée du courant différentiel résiduel (Iₘ, I'ₘ) au moyen d'une interface données,
la génération du signal d'horloge (C) au moyen d'un montage en série fermé d'éléments inverseurs ayant au moins une rétroaction (34).

5. Procédé de mesure selon la revendication 4,
**caractérisé en ce que**
la valeur mesurée du courant différentiel résiduel (Iₘ) est obtenue dans le dispositif d'évaluation (42) à partir des durées de temporisation (Tₕ, Tₗ) au moyen d'algorithmes de filtrage numériques.

6. Procédé de mesure selon la revendication 4 ou la revendication 5, **caractérisé en ce que**
la valeur mesurée du courant différentiel résiduel (Iₘ, I'ₘ) est sortie comme signal analogique et/ou numérique au moyen de l'interface données (52).
